# EUROPÄISCHE PATENTSCHRIFT

(11) **EP 0 895 655 B1**
(45) Veröffentlichungstag und Bekanntmachung des Hinweises auf die Patenterteilung: **18.02.2004**
(21) Anmeldenummer: 97915453.1
(22) Anmeldetag: 27.03.1997
(51) Int. Cl.: H01L 21/00

(54) **VORRICHTUNG ZUM BEHANDELN VON SUBSTRATEN IN EINEM FLUID-BEHÄLTER**
DEVICE FOR TREATING SUBSTRATES IN A FLUID CONTAINER
DISPOSITIF POUR TRAITER DES SUBSTRATS DANS UN RECIPIENT POUR FLUIDE

(30) Priorität: 24.04.1996 DE 19616402
(43) Veröffentlichungstag der Anmeldung: 10.02.1999
(60) Teilanmeldung: 02005774.1
(73) Patentinhaber: STEAG MicroTech GmbH, 72124 Pliezhausen (DE)
(72) Erfinder: WEBER, Martin, D-78073 Bad Dürrheim (DE); OSHINOWO, John, D-78054 Schwenningen (DE)
(74) Vertreter: Wagner, Karl H., Dipl.-Ing.
(86) Internationale Anmeldenummer: PCT/EP1997/001580
(87) Internationale Veröffentlichungsnummer: WO 1997/040524

(56) Entgegenhaltungen:
- DE-A- 4 413 077
- US-A- 4 092 176
- US-A- 4 753 258
- US-A- 5 474 616
- US-A- 5 488 964
- US-A- 5 520 205

## Beschreibung

Die Erfindung betrifft eine Vorrichtung zum Behandeln von Substraten in einem Fluid-Behälter, der auf der Oberseite seiner Seitenwände Überlauföffnungen aufweist.

Vorrichtungen dieser Art sind beispielsweise aus der US-PS 5 275 184 oder der auf dieselbe Anmelderin zurückgehenden DE-A-44 13 077 bekannt, bei der ein Fluid über eine Einlaßöffnung bzw. einen Diffusor in das Fluid-Becken eingeleitet wird und über einen Überlauf am oberen Ende aus ihm ausströmt. Bei Verwendung einer einzigen Zuströmöffnung am Boden des Fluidbehälters ist die pro Zeiteinheit einströmende Menge sowie die Geschwindigkeit des einströmenden Fluids begrenzt. Insbesondere ist es damit nicht möglich, im Behälter gleichmäßige Strömungsverhältnisse zu erreichen, um die im Fluid-Becken zu behandelnden Substrate oder Wafer über die gesamte Substratbreite oder -fläche hinweg gleichmäßig mit dem Fluid zu beaufschlagen bzw. zu umspülen. Bei Verwendung eines Diffusors ist es zwar möglich, das einströmende Fluid im Fluid-Behälter besser über die Fluidfläche hinweg zu verteilen, die pro Zeiteinheit einströmende Fluid-Menge und insbesondere auch die Einströmgeschwindigkeit des Fluids ist bei der Verwendung von Diffusoren aber stark beschränkt.

Aus der US-A-4 092 176 ist eine Vorrichtung zum Waschen von Halbleiter-Wafern bekannt, bei der die Waschflüssigkeit über eine perforierte Platte von unten in den Behälter eingeleitet wird. Unterhalb der perforierten Platte befinden sich Düsen, die die Waschflüssigkeit von unten auf die perforierte Platte richten.

Aus der US-A-4 753 258 ist eine Vorrichtung zum Behandeln von Substraten in einem Fluid- Behälter bekannt, der auf der Oberseite seine Seitenwände Überlauföffnungen aufweist und der in seinem Boden Einlaßöffnungen aufweist.

Der Erfindung liegt die Aufgabe zugrunde, eine Vorrichtung zur Behandlung von Substraten in einem Fluid-Behälter zu schaffen, die optimale Strömungsverhältnisse im Fluidbehälter ermöglicht und große Umwälz- bzw. Fließgeschwindigkeiten zuläßt.

Die gestellte Aufgabe wird erfindungsgemäß durch eine Vorrichtung gemäß Anspruch 1 gelöst. Die Vorrichtung weist Düsen im Behälter-Boden auf, sowie Freispül-Einlaßöffnungen gelöst, die im Behälter-Boden zwischen den Düsen zum Freispülen von Bereichen zwischen den Düsen vorgesehen sind. Auf diese Weise ist es möglich, auch die Zwischenräume zwischen den Düsen und die toten Winkel freizuspülen.

Die Freispül-Einlaßöffnungen sind vorteilhafterweise matrixförmig angeordnet. Gemäß einer weiteren Ausführungsform der Erfindung stehen sie dabei vorteilhafterweise ebenso wie die Düsen mit einem darunterliegenden Zuführraum in Verbindung.

Aufgrund mehrerer Düsen ist es möglich, das Fluid mit den gewünschten Strömungsverhältnissen bzw. zum Erreichen gewünschter Strömungsverhältnisse im Fluid-Behälter einströmen zu lassen, so daß der gesamte zu behandelnde Substratbereich gleichmäßig von dem Fluid umspült und beaufschlagt wird. Durch die Verwendung von Düsen zur Einleitung des Fluids ist es auch möglich, das Fluid mit hohen Einströmgeschwindigkeiten und hohen Durchflußmengen pro Zeiteinheit in den Fluid-Behälter einzubringen und in ihm strömen zu lassen, so daß bei Aufrechterhaltung eines laminaren Stromes extrem hohe Fließgeschwindigkeiten erreicht werden. Dadurch wird nicht nur die Behandlung der Substrate verbessert, sondern auch der Behandlungsvorgang verkürzt, so daß die Produktivität der Vorrichtung erhöht wird.

Gemäß besonders vorteilhaften Ausgestaltungen der Erfindung weisen wenigstens einige Düsen unterschiedliche Abstrahlwinkel auf. Die Abstrahlformen der Düsen können vorzugsweise kegelförmig, aber auch fächerförmig sein, so daß die Einleitung des Fluids je nach den Gegebenheiten des Einzelfalles und der Lage der Düsen im Hinblick auf eine gleichmäßige, laminare Strömung im Fluid-Behälter und eine gleichmäßige Beaufschlagung der Substrate mit dem Fluid optimierbar ist.

Die Düsen sind im Boden des Fluid-Behälters und gemäß einer besonders vorteilhaften Ausführungsform matrixartig verteilt auf dem Boden des Behälters angeordnet. Auf diese Weise ergibt sich eine gleichmäßige Verteilung der Fluid-Zufuhr über die gesamte Fläche des Fluid-Behälters hinweg und insbesondere ist es auch möglich, in den Randbereichen optimale Strömungsverhältnisse zu schaffen.

Die Düsen sind vorteilhafterweise zu Düsengruppen zusammengefaßt, die vorzugsweise an unterschiedlichen Bodenbereichen des Behälters angeordnet sind. Vorteilhaft ist es, wenn eine Düsengruppe im mittleren Bereich und jeweils eine Düsengruppe in den beiden Außenbereichen vorgesehen ist, wobei die Dichte und Anzahl der Düsen in den einzelnen Bereichen unterschiedlich gewählt sein kann. Vorteilhaft ist es auch, wenn die einzelnen Düsen und/oder Düsengruppen voneinander getrennte Fluid-Versorgungseinrichtungen aufweisen, so daß die Düsen mit unterschiedlichem Fluid-Druck beaufschlagbar sind.

Gemäß einer sehr vorteilhaften Ausführungsform der Erfindung ist unter dem Boden des Fluid-Behälters ein Fluid-Zuführraum vorgesehen, mit dem die Düsen in Verbindung stehen. Dabei ist der Fluid-Zuführraum gemäß einer weiteren Ausführungsform der Erfindung in Teilräume für einzelne Düsen und/oder Düsengruppen unterteilt.

Der Fluid-Zuführraum unterhalb des Behälter-Bodens ist vorzugsweise in Form eines Zwischenraums zwischen einem doppelten Boden ausgebildet.

Gemäß einer weiteren sehr vorteilhaften Ausführungsform der Erfindung ist der Boden des Fluid-Behälters geneigt, vorzugsweise fällt der Boden jeweils zur Mitte, etwa zu einer Mittellinie oder zu einem Mittelpunkt des Fluid-Behälters hin ab. Auf diese Weise kann der Fluid-Behälter bei Ablassen des Fluids nach unten schnell und vollständig entleert werden.

Zum schnellen Ablassen des Fluids ist im Fluid-Behälter, und dort insbesondere in der Mitte bzw. in der Mittellinie, eine verschließbare Öffnung vorgesehen, die einen großen Durchmesser aufweist. Im Falle eines Stromausfalls oder einer sonstigen Unregelmäßigkeit, aber auch im Zusammenhang mit gängigen Verfahrensschritten ist es auf diese Weise möglich, die im Fluid-Behälter befindlichen Substrate schnell von dem Behandlungs-Medium, beispielsweise ätzenden Substanzen, zu befreien. Zur Aufnahme des schnell abgelassenen Fluids ist vorzugsweise unterhalb des Fluidbeckens ein Auffangbehälter vorgesehen.

Eine weitere Ausführungsform der Erfindung besteht darin, zusätzlich zu den Düsen auf dem Behälter-Boden Düsen an den Seitenwänden des Fluid-Behälters vorzusehen, um auf diese Weise auch seitlich oder im Bereich des Übergangs des Fluid-Bodens zu den Seitenwänden Fluid in den Fluid-Behälter einzuleiten, damit die Strömungsverhältnisse weiter verbessert oder dadurch das Umwälzvolumen erhöht werden bzw. wird.

Gemäß einer weiteren sehr vorteilhaften Ausführungsform der Erfindung sind Düsen und/oder Düsengruppen für unterschiedliche Fluids vorgesehen. Die einzelnen Düsen und/oder Düsengruppen für unterschiedliche Gruppen sind dabei auch hinsichtlich der Zuleitungen und Pumpen voneinander getrennt, so daß die unterschiedlichen Fluids, etwa unterschiedliche Chemikalien, durch Düsen- und/oder Düsengruppen eingeleitet werden, die den Chemikalien zugeordnet sind. Auf diese Weise ist ein Fluid-Wechsel schnell und ohne die Gefahr einer Vermischung möglich, da an die jeweiligen Düsen immer nur die diesen Düsen zugeordneten Fluids gelangen.

Gemäß einer weiteren sehr vorteilhaften Ausführungsform der Erfindung können zusätzlich zu den über die Düsen eingeleiteten Fluids weitere Fluids, beispielsweise zusätzliche Chemikalien, Gase, Ozon, Wasser usw. in den Fluid-Behälter eingeleitet. Insbesondere zur zusätzlichen Einleitung von Chemikalien, Gasen, Ozon oder Wasser ist im Fluid-Behälter wenigstens ein Diffusor vorgesehen.

Sehr vorteilhaft ist auch eine Ausführungsform der Erfindung, bei der Sprühdüsen im oberen Bereich des Fluid-Behälters, etwa an den Seitenwänden angeordnet sind, die zur Reinigung des Fluid-Behälters und/oder dazu dienen, die Substrate zwischen unterschiedlichen im selben Fluid-Behälter ablaufenden Verfahren, etwa zwischen dem Ätzprozess, dem Reinigungsprozess und dem Trocknungsvorgang zu befeuchten bzw. naß zu halten. Vorzugsweise werden hierfür Aerosole, Wasser, sonstige Chemikaliendämpfe eingesprüht, oder auch Fluids die auch von unten in die Fluid-Behälter eingeleitet werden.

Eine weitere vorteilhafte Ausführungsform der Erfindung besteht darin, eine über das Fluid-Becken bringbare Haube zu verwenden, die vorzugsweise wenigstens eine Fluid-Einlaßöffnung, insbesondere zum Einlassen eines Fluids für den Trocknungsvorgang nach dem MARANGONI-Prinzip, aufweist. Um Wiederholungen zu dieser Ausführungsform zu vermeiden, wird insbesondere auf die DE-A-44 13 077 sowie die nicht vorveröffentlichten, auf dieselbe Anmelderin zurückgehenden DE-A-195 00 239, DE-A-196 15 108 und DE-A-196 15 970, angemeldet am 22. April 1996, verwiesen.

Vorteilhaft ist weiterhin die Verwendung einer Heiz- und/oder Kühleinrichtung zum Erwärmen und/oder Kühlen des Fluids im Fluid-Behälter, mit der die Fluid-Temperatur auf einen wählbaren, optimalen Wert einstellbar ist. Auch ist die Verwendung einer Ultraviolett-Lichtquelle vorteilhaft, die am Boden und/oder an den Seitenwänden des Fluid-Behälters angeordnet ist.

Eine weitere vorteilhafte Ausgestaltung der Erfindung besteht darin, einen Substrat-Niederhalter etwa in Form einer Halteleiste vorzusehen, die auf den oberen Randbereich der Substrate auflegbar ist. Um Wiederholungen hierzu zu vermeiden, wird auf die auf dieselbe Anmelderin zurückgehende DE-A-196 15 970, angemeldet am 22. April 1996, verwiesen.

Vorteilhaft ist weiterhin eine Megasonic-Abstrahlvorrichtung, die vorzugsweise in Form eines Megasonic-Transducers im Fluid-Behälter integriert ist bzw. sind. Ein vorteilhafter Anbringungsort ist dafür die vom Boden und den Seitenwänden gebildeten Ecken des Fluid-Behälters, wobei die Abstrahlrichtung bezüglich der Horizontalen vorzugsweise 45° beträgt.

Da mit der erfindungsgemäßen Vorrichtung der Behälter sehr schnell gefüllt werden kann, und eine starke Düsenwirkung beim Einbringen des Fluids in den Behälter auftritt, ist insbesondere eine Vorrichtung zum Abdecken des Fluid-Behälters vorteilhaft, die verhindert, daß Fluid in Form von Spritzern in eine vorhandene Haube gelangt, die vorzugsweise für den Trocknungsvorgang eingesetzt wird.

Die erfindungsgemäße Vorrichtung ist vorzugsweise mit einer Fluid-Aufbereitungseinrichtung verbunden, in der Fluids oder Fluidmischungen aufgefangen und aufbereitet werden, so daß sie wiederverwendet werden können und vorzugsweise in den Fluid-Behälter rückgeführt werden.

Vorteilhaft ist weiterhin eine Trenn-Anlage, in der die in der Abluft enthaltenen alkalischen und Säuredämpfe getrennt werden.

Insbesondere für die Behandlungs- und Spülvorgänge ist es vorteilhaft, wenn die Substrate im Fluid-Behälter gedreht werden können. Dafür ist vorzugsweise eine Vorrichtung vorgesehen, die die Substrate im Fluid-Behälter dreht.

Es ist vorteilhaft, die Fluids bei der Verwendung von Fluid-Mischungen vor dem Einbringen in den Fluid-Behälter vorzumischen.

Die Erfindung wird nachfolgend anhand von bevorzugten Ausführungsbeispielen unter Bezugnahme auf die Figuren erläutert. Es zeigen:
- Fig. 1: eine Ausführungsform der erfindungsgemäßen Vorrichtung im Querschnitt,
- Fig. 2: die in der Figur 1 gezeigte Vorrichtung in Aufsicht bzw. mit Blickrichtung von oben in den Fluid-Behälter, und
- Fig. 3: einen Querschnitt entlang einer Querschnittsfläche, die gegenüber der Querschnittsfläche der in Figur 1 gezeigten Darstellung um 90° gedreht ist.

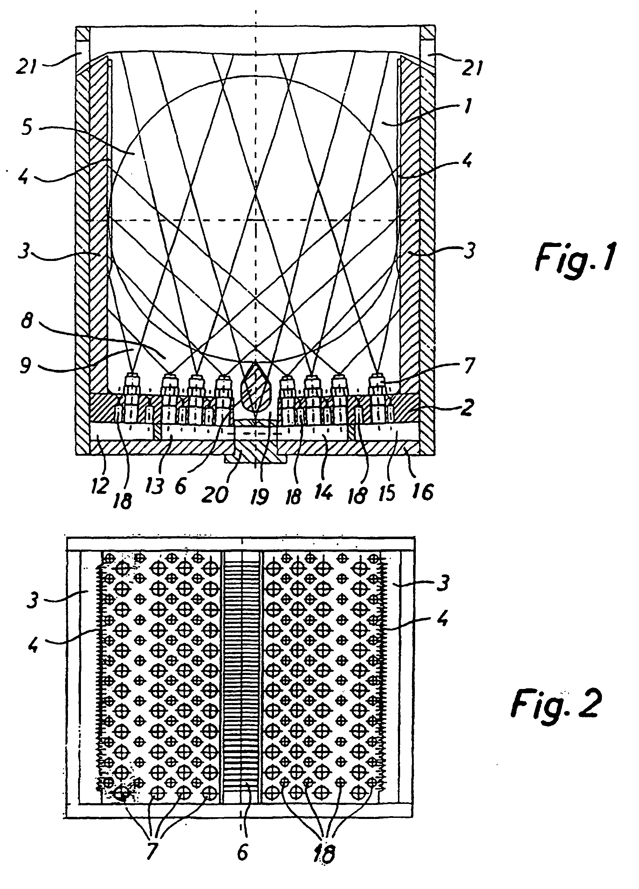

Wie aus den Figuren ersichtlich ist, weist der Fluid-Behälter 1 der erfindungsgemäßen Vorrichtung einen Boden 2 und Seitenwände 3 auf. Auf den in Figur 1 gegenüberliegenden Seitenwänden 3 sind Schlitze 4 vorgesehen, in denen Substrat-Scheiben 5 geführt sind, und die auf einer Substrat-Aufnahmevorrichtung 6 stehen, die mittels einer nicht dargestellten Antriebsvorrichtung in vertikaler Richtung beweglich ist und die Wafer 5 in den Fluid-Behälter 1 absenkt und aus ihm herausfährt. Die Substrat-Aufnahmevorrichtung 6 besteht bei dem dargestellten Ausführungsbeispiel aus einem messerartigen Steg mit Schlitzen oder Kerben, die entsprechend dem Abstand zwischen den Führungsschlitzen 4 in den einander gegenüberliegenden Seitenwänden 3 beabstandet sind.

Wie am besten aus Figur 1 ersichtlich ist, ist der Boden 2 auf beiden Seiten einer Mittellinie nach innen geneigt, so daß ein Fluid bei Entleerung des Behälters 1 in der Mitte nach unten ausströmt.

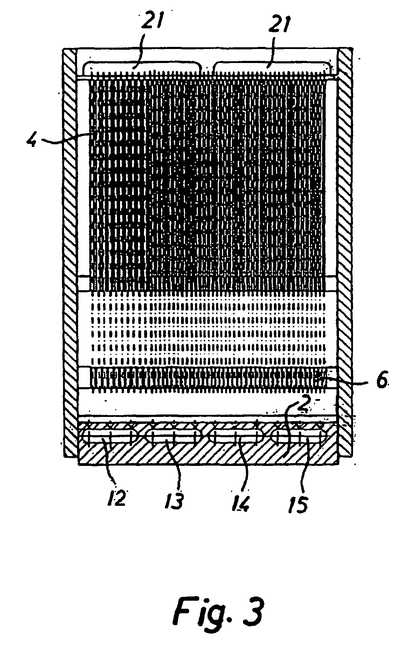

Der Boden 2 weist eine Vielzahl von Düsen 7 auf, die matrixförmig angeordnet sind, wie dies am besten aus Figur 2 zu ersehen ist. Die Düsen weisen unterschiedliche Düsenaustritts- bzw. Abstrahlwinkel 8, 9 auf, wie dies in Figur 1 eingezeichnet ist. Aufgrund der unterschiedlichen Abstrahlwinkel bzw. aufgrund der unterschiedlichen Abstrahlformen ergibt sich eine gute, gleichmäßige laminare Strömung über das gesamte Fluid-Behälterprofil hinweg und die Substrate 5 werden über die gesamte Breite hinweg gleichmäßig mit dem aus den Düsen 7 austretenden Fluid beaufschlagt.

Aus Figur 1 ist ersichtlich, daß unterhalb des Bodens 2 Hohlräume 12, 13, 14, 15 ausgebildet sind, die nach unten durch eine Abschlußplatte 16 abgeschlossen sind. Über die Hohlräume 12 bis 15 wird das Fluid den mit den jeweiligen Hohlräumen in Verbindung stehenden Düsen 7 zugeleitet.

Zwischen den Düsen 7 sind im Boden 2 Freispül-Einlaßöffnungen 18 vorgesehen, die entsprechend Figur 2 ebenfalls matrixförmig auf dem Boden 2 des Fluid-Behälters 1 verteilt sind. Die Freispül-Einlaßöffnungen 18 spülen die Bereiche des Bodens 2 zwischen den Düsen 7 frei und stehen ebenfalls für die Fluid-Zufuhr mit entsprechenden Fluid-Zuführräumen 12 bis 15 unterhalb des Bodens 2 in Verbindung.

Wie Figur 1 zeigt, ist in der Mitte des Bodens 2 eine Öffnung 19 für das schnelle Ablassen des im Fluid-Behälter 1 befindlichen Fluids vorgesehen, etwa dann, wenn Stromausfall eintritt und/oder die sich im Fluid-Behälter 1 befindenden Substrate 5 schnell aus der Fluid-Umgebung, beispielsweise einem Ätz-Medium, befreit werden müssen. Bei Öffnen eines Verschlusses 20 wird das Fluid innerhalb eines kleinen Zeitraums in einen nicht dargestellten, unter dem Fluid-Behälter 1 angeordneten Auffangbehälter entleert.

Die Substrat-Aufnahmevorrichtung 6 befindet sich im Bereich oberhalb des Verschlusses 20 teilweise innerhalb des Bodens 2 und ragt nur zu einem geringen Teil über die Düsenöffnungen nach oben hinaus. Dadurch ist innerhalb des Fluid-Behälters 1 nur wenig zusätzlicher Raum für die Substrat-Aufnahmevorrichtung erforderlich, so daß das Fluid-Volumen im Fluid-Behälter 1 klein gehalten werden kann.

Auf der Oberseite der Seitenwände 3 befinden sich Überlauf-Öffnungen 21, über die das von unten einströmende Fluid abfließt.

Die Erfindung wurde zuvor anhand eines bevorzugten Ausführungsbeispiels erläutert. Dem Fachmann sind jedoch zahlreiche Abwandlungen und Ausgestaltungen möglich, ohne daß dadurch der Erfindungsgedanke verlassen wird. Beispielsweise ist über dem Fluid-Behälter 1 eine Haube anbringbar, oder es sind an den Seitenwänden 3 des Fluid-Behälters 1, beispielsweise im oberen Bereich, Sprühdüsen zum Reinigen des Beckens oder zum Besprühen der Substrate 5 zwischen den einzelnen Verfahrensschritten und Behandlungsprozessen vorgesehen. Auch ist der Einsatz von Megasonic-Transducern, von Ultraviolett-Lichtquellen oder von Vorrichtungen zum Drehen der Wafer 5 im Fluid-Behälter 1 möglich, wie dies zuvor bereits beschrieben wurde.

## Patentansprüche

1. Vorrichtung zum Behandeln von Substraten (5) mit einem Fluid-Behälter (1), der auf der Oberseite seiner Seitenwände (3) Überlauföffnungen (21) aufweist, **dadurch gekennzeichnet, daß** ein Düsensystem mit mehreren Düsen (7) im Behälterboden (2) zum Einleiten eines Fluids vorgesehen ist, und daß Freispül-Einlaßöffnungen (18) im Behälterboden (2) zwischen den Düsen (7) zum Freispülen von Bereichen zwischen den Düsen (7) vorgesehen sind.

2. Vorrichtung nach Anspruch 1, **dadurch gekennzeichnet, daß** die Freispül-Einlaßöffnungen (8) matrixförmig verteilt auf dem Boden (2) des Fluid-Behälters (1) angeordnet sind.

3. Vorrichtung nach Anspruch 1 oder 2, **dadurch gekennzeichnet, daß** die Freispül-Einlaßöffnungen (18) mit einem darunterliegenden Fluid-Zuführraum (12, 13, 14, 15) in Verbindung stehen.

4. Vorrichtung nach einem der vorhergehenden Ansprüche, **dadurch gekennzeichnet, daß** die Düsen (7) zu Düsengruppen zusammengefaßt sind.

5. Vorrichtung nach einem der vorhergehenden Ansprüche, **dadurch gekennzeichnet, daß** die Düsen (7) und/oder Düsengruppe für unterschiedliche Fluids vorgesehen sind.

6. Vorrichtung nach Anspruch 5, **dadurch gekennzeichnet, daß** Zuleitungen zu den für unterschiedliche Fluids vorgesehene Düsen (7) und/oder Düsengruppen jeweils getrennt voneinander vorgesehen sind.

7. Vorrichtung nach einem der vorhergehenden Ansprüche, **dadurch gekennzeichnet, daß** einzelne Düsen (7) und/oder Düsengruppen voneinander getrennte Fluid-Versorgungseinrichtungen aufweisen.

8. Vorrichtung nach Anspruch 3, oder nach Anspruch 3 mit einem der Ansprüche 4-7, **dadurch gekennzeichnet, daß** der Fluid-Zuführraum in Fluid-Teilräume (12, 13, 14, 15) für einzelne Düsen (7) und/oder Düsengruppen unterteilt ist.

9. Vorrichtung nach Anspruch 3, oder nach Anspruch 3 mit einem der Ansprüche 4 bis 8, **dadurch gekennzeichnet, daß** der Fluid-Zuführraum (12, 13, 14, 15) durch einen Zwischenraum zwischen einem doppelten Boden (2, 16) gebildet ist.

10. Vorrichtung nach einem der vorhergehenden Ansprüche, **dadurch gekennzeichnet, daß** wenigstens einige Düsen (7) unterschiedliche Abstrahlwinkel (8,9) aufweisen.

11. Vorrichtung nach einem der vorhergehenden Ansprüche, **dadurch gekennzeichnet, daß** wenigstens eine Düse (7) eine fächerförmige Abstrahlform aufweist.

12. Vorrichtung nach einem der vorhergehenden Ansprüche, **dadurch gekennzeichnet, daß** wenigstens eine Düse (7) eine kegelförmige Abstrahtform aufweist.

13. Vorrichtung nach einem der vorhergehenden Ansprüche, **dadurch gekennzeichnet, daß** die Düsen (7) matrixförmig verteilt auf dem Behälter-Boden (2) angeordnet sind.

14. Vorrichtung nach Anspruch 4, oder nach Anspruch 4 mit einem der Ansprüche 5-13, **dadurch gekennzeichnet, daß** die Düsengruppen an unterschiedlichen Boden-Bereichen des Fluid-Behälters (1) angeordnet sind.

15. Vorrichtung nach Anspruch 4, oder nach Anspruch 4 mit einem der Ansprüche 5-13, **dadurch gekennzeichnet, daß** eine Düsengruppe im mittleren Bereich und jeweils eine Düsengruppe in den beiden Außenbereichen des Bodens (2) vorgesehen ist.

16. Vorrichtung nach einem der vorhergehenden Ansprüche, **dadurch gekennzeichnet, daß** der Boden des Fluid-Behälters (1) geneigt ist.

17. Vorrichtung nach Anspruch 16, **dadurch gekennzeichnet, daß** der Boden (2) jeweils zur Mitte des Fluid-Behälters (1) hin abfällt.

18. Vorrichtung nach einem der vorhergehenden Ansprüche, **gekennzeichnet, durch** eine Öffnung (19) zum schnellen Ablassen des Fluids aus dem Fluid-Behälter (1).

19. Vorrichtung nach Anspruch 18, **gekennzeichnet durch** einen Auffangbehälter unterhalb des Fluid-Behälters(1) für das schnelle Ablassen des Fluids.

20. Vorrichtung nach einem der vorhergehenden Ansprüche, **dadurch gekennzeichnet, daß** Düsen (7) an den Seitenwänden (3) des Fluid-Behälters (1) vorgesehen sind.

21. Vorrichtung nach einem der vorhergehenden Ansprüche, **dadurch gekennzeichnet, daß** die Düsen zum Einleiten mehrere Fluids in den Fluid-Behälter (1) vorgesehen sind.

22. Vorrichtung nach Anspruch 21, **dadurch gekennzeichnet, daß** die zusätzlichen Fluids Chemikalien, Gase, Ozon und/oder Wasser sind.

23. Vorrichtung nach Anspruch 21 oder 22, **dadurch gekennzeichnet, daß** wenigstens ein Diffusor zum Einleiten zusätzlicher Fluids vorgesehen ist.

24. Vorrichtung nach einem der vorhergehenden Ansprüche, **gekennzeichnet durch** Sprühdüsen, die an den Seitenwänden vorzugsweise im oberen Bereich des Fluid-Behälters (1) angeordnet sind.

25. Vorrichtung nach Anspruch 24, **dadurch gekennzeichnet, daß** die Sprühdüsen zum Einsprühen von Chemikalien vorgesehen sind.

26. Vorrichtung nach einem der vorhergehenden Ansprüche, **gekennzeichnet durch** eine Vorrichtung zum Abdecken des Fluid-Behälters (1).

27. Vorrichtung nach einem der vorhergehenden Ansprüche, **gekennzeichnet durch** wenigstens eine Substrat-Halteleiste, die zum Aufliegen auf den Substraten (5) im oberen Randbereich vorgesehen ist.

28. Vorrichtung nach einem der vorhergehenden Ansprüche, **gekennzeichnet durch** eine über das Fluid-Becken (1) bringbare Haube.

29. Vorrichtung nach Anspruch 28, **dadurch gekennzeichnet, daß** die Haube wenigstens eine Fluid-Einlaßöffnung aufweist.

30. Vorrichtung nach einem der vorhergehenden Ansprüche, **gekennzeichnet durch** eine Heiz- und/oder Kühleinrichtung zum Erwärmen und/oder Abkühlen des Fluids im Fluid-Behälter (1).

31. Vorrichtung nach einem der vorhergehenden Ansprüche, **gekennzeichnet durch** eine Fluid-Aufbereitungseinrichtung.

32. Vorrichtung nach einem der vorhergehenden Ansprüche, **gekennzeichnet durch** eine Trenn-Anlage zum Trennen von in der Abluft enthaltenen alkalischen und Säuredämpfen.

33. Vorrichtung nach einem der vorhergehenden Ansprüche, **gekennzeichnet durch** Ultraviolett-Lichtquellen, die am Boden (2) und/oder an den Seitenwänden (3) des Fluid-Behälters (1) angeordnet sind.

34. Vorrichtung nach einem der vorhergehenden Ansprüche, **gekennzeichnet durch** wenigstens eine Megasonic-Abstrahl-Vorrichtung.

35. Vorrichtung nach Anspruch 34, **dadurch gekennzeichnet, daß** die Megasonic-Abstrahl-Vorrichtung in den vom Boden (2) und den Seitenwänden (3) gebildeten Ecken des Fluid-Behälters (1) angeordnet ist.

36. Vorrichtung nach einem der vorhergehenden Ansprüche, **gekennzeichnet durch** eine die Substrate (5) im Fluid-Behälter (1) drehende Vorrichtung.

## Claims

1. Device for treating substrates (5), with a fluid container (1), which has overflow openings (21) on the upper side of its side walls (3), **characterised in that** a nozzle system with several nozzles (7) is provided in the container base (2) for conducting in a fluid and that washing-free inlet openings (18) are provided in the container base (2) between the nozzles (7) for washing-free regions between the nozzles (7).

2. Device according to claim 1, **characterised in that** the washing-free inlet openings (8) are arranged to be distributed in matrix form on the base (2) of the fluid container (1).

3. Device according to claim 1 or 2, **characterised in that** the washing-free inlet openings (18) are connected with a fluid feed chamber (12, 13, 14, 15) disposed thereunder.

4. Device according to one of the preceding claims, **characterised in that** the nozzles (7) are combined into nozzle groups.

5. Device according to one of the preceding claims, **characterised in that** the nozzles (7) and/or nozzle groups are provided for different fluids.

6. Device according to claim 5, **characterised in that** feed ducts to the nozzles (7) and/or nozzle groups provided for different fluids are provided to be respectively separate from one another.

7. Device according to one of the preceding claims, **characterised in that** the individual nozzles (7) and/or nozzle groups have fluid supply devices separate from one another.

8. Device according to claim 3 or according to claim 3 together with one of claims 4 to 7, **characterised in that** the fluid feed chamber is subdivided into fluid part chambers (12, 13, 14, 15) for individual nozzles (7) and/or nozzle groups.

9. Device according to daim 3 or according to claim 3 together one of claims 4 to 8, **characterised in that** the fluid feed chamber (12, 13, 14, 15) is formed by an intermediate space between a double base (2, 16).

10. Device according to one of the preceding claims, **characterised in that** at least some nozzles (7) have different angles (8, 9) of radiation.

11. Device according to one of the preceding claims, **characterised in that** at least one nozzle (7) has a fan-shaped radiation pattern.

12. Device according to one of the preceding claims, **characterised in that** at least one nozzle (7) has a cone-shaped radiation pattern.

13. Device according to one of the preceding claims, **characterised in that** the nozzles (7) are arranged to be distributed in matrix form on the container base (2).

14. Device according to claim 4 or according to claim 4 together with one of claims 5 to 13, **characterised in that** the nozzle groups are arranged at different base regions of the fluid container (1).

15. Device according to claim 4 or according to claim 4 together with one of claims 5 to 13, **characterised in that** one nozzle group is provided in the middle region and a respective nozzle group is provided in each of the two outer regions of the base (2).

16. Device according to one of the preceding claims, **characterised in that** the base of the fluid container (1) is inclined.

17. Device according to claim 16, **characterised in that** the base (2) drops away each time towards the centre of the fluid container (1).

18. Device according to one of the preceding claims, **characterised by** an opening (19) for rapid discharge of the fluid from the fluid container (1).

19. Device according to claim 18, **characterised by** a collecting container below the fluid container (1) for the rapid discharge of the fluid.

20. Device according to one of the preceding claims, **characterised in that** nozzles (7) are provided at the side walls (3) of the fluid container (1).

21. Device according to one of the preceding claims, **characterised in that** the nozzles are provided for conducting several fluids into the fluid container (1).

22. Device according to claim 21, **characterised in that** the additional fluids are chemicals, gases, ozone and/or water.

23. Device according to claim 21 or 22, **characterised in that** at least one diffuser for conducting in additional fluids is provided.

24. Device according to one of the preceding claims, **characterised by** spray nozzles which are arranged at the side walls, preferably in the upper region of the fluid container (1).

25. Device according to claim 24, **characterised in that** the spray nozzles are provided for spraying in chemicals.

26. Device according to one of the preceding claims, **characterised by** a device for covering the fluid container (1).

27. Device according to one of the preceding claims, **characterised by** at least one substrate retaining strip which is provided for resting on the substrates (5) in the upper edge region.

28. Device according to one of the preceding claims, **characterised by** a hood placeable over the fluid tank (1).

29. Device according to claim 28, **characterised in that** the hood has at least one fluid inlet opening.

30. Device according to one of the preceding claims, **characterised by** a heating and/or cooling device for heating and/or cooling the fluid in the fluid container (1).

31. Device according to one of the preceding claims, **characterised by** a fluid preparation device.

32. Device according to one of the preceding claims, **characterised by** a separating installation for separation of alkaline and acidic vapours contained in the exhaust air.

33. Device according to one of the preceding claims, **characterised by** ultraviolet light sources which are arranged at the base (2) and/or at the side walls (3) of the fluid container (1).

34. Device according to one of the preceding claims, **characterised by** at least one megasonic radiation device.

35. Device according to claim 34, **characterised in that** the megasonic radiation device is arranged in the corners, which are formed by the base (2) and the side walls (3), of the fluid container (1).

36. Device according to one of the preceding claims, **characterised by** a device rotating the substrates (5) in the fluid container (1).

## Revendications

1. Dispositif de traitement de substrats (5) avec un récipient de fluide (1) qui présente au côté supérieur de ses parois latérales (3) des ouvertures de trop-plein (21), **caractérisé en ce qu'**il est prévu un système à buses avec plusieurs buses (7) dans le fond (2) du récipient pour l'introduction d'un fluide, et **en ce que** sont prévues des ouvertures d'admission de rinçage (18) dans le fond (2) du récipient entre les buses (7) pour rincer les zones entre les buses (7).

2. Dispositif selon la revendication 1, **caractérisé en ce que** les ouvertures d'admission de rinçage (8) sont disposées selon une répartition en forme de matrice sur le fond (2) du récipient de fluide (1).

3. Dispositif selon la revendication 1 ou 2, **caractérisé en ce que** les ouvertures d'admission de rinçage (18) sont en liaison avec un espace d'amenée de fluide (12, 13, 14, 15) situé en dessous.

4. Dispositif selon l'une des revendications précédentes, **caractérisé en ce que** les buses (7) sont réunies en groupes de buses.

5. Dispositif selon l'une des revendications précédentes, **caractérisé en ce que** les buses (7) et/ou les groupes de buses sont prévus pour des fluides différents.

6. Dispositif selon la revendication 5, **caractérisé en ce que** des conduits d'amenée vers les buses (7) et/ou groupes de buses prévus pour des fluides différents sont prévus respectivement séparément les uns des autres.

7. Dispositif selon l'une des revendications précédentes, **caractérisé en ce que** des buses (7) et/ou groupes de buses individuels présentent des installations d'alimentation en fluide séparées les unes des autres.

8. Dispositif selon la revendication 3, ou selon la revendication 3 avec l'une des revendications 4 à 7, **caractérisé en ce que** l'espace d'amenée de fluide est subdivisé en des espaces partiels de fluide (12, 13, 14, 15) pour des buses (7) et/ou groupes de buses individuels.

9. Dispositif selon la revendication 3, ou selon la revendication 3 avec l'une des revendications 4 à 8, **caractérisé en ce que** l'espace d'amenée de fluide (12, 13, 14, 15) est formé par un espace intermédiaire entre un fond double (2, 16).

10. Dispositif selon l'une des revendications précédentes, **caractérisé en ce qu'**au moins quelques buses (7) ont des angles de rayonnement différents (8, 9).

11. Dispositif selon l'une des revendications précédentes, **caractérisé en ce qu'**au moins une buse (7) présente une forme de rayonnement en forme d'éventail.

12. Dispositif selon l'une des revendications précédentes, **caractérisé en ce qu'**au moins une buse (7) présente une forme de rayonnement conique.

13. Dispositif selon l'une des revendications précédentes, **caractérisé en ce que** les buses (7) sont disposées selon une répartition en forme de matrice sur le fond (2) du récipient.

14. Dispositif selon la revendication 4, ou selon la revendication 4 avec l'une des revendications 5-13, **caractérisé en ce que** les groupes de buses sont disposés dans des zones de fond différentes du récipient de fluide (1).

15. Dispositif selon la revendication 4, ou selon la revendication 4 avec l'une des revendications 5 à 13, **caractérisé en ce qu'**il est prévu un groupe de buses dans la zone médiane et respectivement un groupe de buses dans les deux zones extérieures du fond (2).

16. Dispositif selon l'une des revendications précédentes, **caractérisé en ce que** le fond du récipient de fluide (1) est incliné.

17. Dispositif selon la revendication 16, **caractérisé en ce que** le fond (2) descend respectivement vers le milieu du récipient de fluide (1).

18. Dispositif selon l'une des revendications précédentes, **caractérisé par** une ouverture (19) pour l'évacuation rapide du fluide du récipient de fluide (1).

19. Dispositif selon la revendication 18, **caractérisé par** un récipient collecteur en dessous du récipient de fluide (1) pour l'évacuation rapide du fluide.

20. Dispositif selon l'une des revendications précédentes, **caractérisé en ce que** les buses (7) sont prévues aux parois latérales (13) du récipient de fluide (1) .

21. Dispositif selon l'une des revendications précédentes, **caractérisé en ce que** les buses sont prévues pour introduire plusieurs fluides dans le récipient de fluide (1).

22. Dispositif selon la revendication 21, **caractérisé en ce que** les fluides additionnels sont des substances chimiques, des gaz, de l'ozone et/ou de l'eau.

23. Dispositif selon la revendication 21 ou 22, **caractérisé en ce qu'**il est prévu au moins un diffuseur pour introduire des fluides additionnels.

24. Dispositif selon l'une des revendications précédentes, **caractérisé par** des buses de pulvérisation qui sont disposées aux parois latérales, de préférence dans la zone supérieure du récipient de fluide (1).

25. Dispositif selon la revendication 24, **caractérisé en ce que** les buses de pulvérisation sont prévues pour la pulvérisation de substances chimiques.

26. Dispositif selon l'une des revendications précédentes, **caractérisé par** un dispositif pour recouvrir le récipient de fluide (1).

27. Dispositif selon l'une des revendications précédentes, **caractérisé par** au moins une baguette de retenue de substrat, qui est prévue pour reposer sur les substrats (5) dans la zone de bord supérieure.

28. Dispositif selon l'une des revendications précédentes, **caractérisé par** un capot pouvant être amené au-dessus du bassin de fluide (1).

29. Dispositif selon la revendication 28, **caractérisé en ce que** le capot présente au moins une ouverture d'admission de fluide.

30. Dispositif selon l'une des revendications précédentes, **caractérisé par** une installation de chauffage et/ou de refroidissement pour chauffer et/ou refroidir le fluide dans le récipient de fluide (1).

31. Dispositif selon l'une des revendications précédentes, **caractérisé par** une installation de préparation de fluide.

32. Dispositif selon l'une des revendications précédentes, **caractérisé par** une installation de séparation pour séparer des vapeurs alcalines et acides se trouvant dans l'air d'échappement.

33. Dispositif selon l'une des revendications précédentes, **caractérisé par** des sources de lumière ultraviolettes qui sont disposées au fond (2) et/ou aux parois latérales (3) du récipient de fluide (1).

34. Dispositif selon l'une des revendications précédentes, **caractérisé par** au moins un dispositif de rayonnement mégasonique.

35. Dispositif selon la revendication 34, **caractérisé en ce que** le dispositif de rayonnement mégasonique est disposé dans les coins du récipient de fluide (1) formés par le fond (2) et les parois latérales (3).

36. Dispositif selon l'une des revendications précédentes, **caractérisé par** un dispositif faisant tourner les substrats (5) dans le récipient de fluide (1).
